# EUROPÄISCHE PATENTSCHRIFT

(11) **EP 3 354 891 B1**
(45) Veröffentlichungstag und Bekanntmachung des Hinweises auf die Patenterteilung: **10.03.2021**
(21) Anmeldenummer: 18151687.3
(22) Anmeldetag: 15.01.2018
(51) Int. Cl.: F02M 35/10

(54) **KRAFTFAHRZEUG MIT VERBRENNUNGSMOTOR UND VORRICHTUNG ZUR ANBRINGUNG EINES STEUERGERÄTS AN DEM VERBRENNUNGSMOTOR**
MOTOR VEHICLE WITH INTERNAL COMBUSTION ENGINE AND DEVICE FOR MOUNTING A CONTROL UNIT ON THE INTERNAL COMBUSTION ENGINE
VÉHICULE À MOTEUR À COMBUSTION INTERNE ET DISPOSITIF DE MONTAGE D'UNE UNITÉ DE COMMANDE SUR LE MOTEUR À COMBUSTION INTERNE

(30) Priorität: 26.01.2017 DE 102017000699
(43) Veröffentlichungstag der Anmeldung: 01.08.2018
(73) Patentinhaber: MAN Truck & Bus SE, 80995 München (DE)
(72) Erfinder: Berner, Armin, 91567 Herrieden (DE)
(74) Vertreter: v. Bezold & Partner Patentanwälte - PartG mbB

(56) Entgegenhaltungen:
- EP-A1- 1 057 674
- EP-A2- 1 422 405
- WO-A1-2005/031133
- CN-U- 205 297 690
- DE-A1-102016 212 738
- US-A1- 2007 243 775
- US-A1- 2016 032 877

## Beschreibung

Die Erfindung betrifft eine Vorrichtung zur Anbringung eines Steuergeräts an einer Komponente eines Verbrennungsmotors. Die Erfindung betrifft ferner einen Verbrennungsmotor mit einer Vorrichtung zur Anbringung eines Steuergeräts an einer Komponente des Verbrennungsmotors. Zudem bezieht sich die Erfindung auf ein Kraftfahrzeug, insbesondere ein Nutzfahrzeug, mit einem Verbrennungsmotor oder einer Vorrichtung zur Anbringung eines Steuergeräts an einer Komponente eines Verbrennungsmotors.

Motorsteuergeräte oder Steuereinheiten können außen an einer Komponente eines Verbrennungsmotors, zum Beispiel einem Kurbelgehäuse, angebaut werden. Aus schwingungstechnischen Gründen werden die Steuergeräte häufig unter Zwischenschaltung von Dämpfungselementen aus elastischen Werkstoffen an dem Verbrennungsmotor angebracht. Die Dämpfungselemente dämpfen die vom Verbrennungsmotor herrührenden Schwingungen, sodass das Steuergerät dem Einsatz am Verbrennungsmotor über die Lebensdauer des Verbrennungsmotors erträgt.

Bei Konstruktionen, in denen das Steuergerät außen am Verbrennungsmotor angebracht wird, erfolgt die Anbringung häufig mittels zweier Konsolen oder Verbindungsbauteilen. Das erste Verbindungsbauteil ist fest mit dem Verbrennungsmotor verbunden. Das zweite Verbindungsbauteil ist fest mit dem Steuergerät verbunden. Zwischen den beiden Konsolen befinden sich die Dämpfungselemente.

Aus der WO 2005/031133 A1 ist es bekannt, eine elektronisches Steuergerät an einem Luftfiltergehäuse anzubringen.

Die EP 1 057 674 A1 offenbart eine elektronische Steuereinheit, die an einer Zylinderkopfabdeckung und einem Lufteinlassrohr angebracht ist.

Die DE 10 2016 212 738 A1 offenbart eine Leistungssteuereinheit, die über schwingungsfeste Hülsen und Lagerabschnitte an einem Gehäuse eines Fahrmotors, eines Getriebes und eines Leistungsverteilungsmechanismus angebracht ist.

Die US 2007/0243775 A1 offenbart einen Außenbordmotor mit einer elektronischen Komponente, die an einem Belüftungsbehälter angebracht ist, der mit einer Einlasssammelleitung verbunden ist.

Im Stand der Technik sind ebenfalls Konstruktionen bekannt, bei denen ein Steuergerät direkt in ein Einlassluftsystem eines Verbrennungsmotors integriert ist, sodass das Steuergerät von der Einlassluft gekühlt werden kann. Derartige Systeme sind beispielsweise in der DE 101 04 568 A1, der US 2002/104490 A1 und der DE 103 03 763 A offenbart.

Ausgehend von einer Konstruktion, bei der ein Steuergerät außen an einer Komponente des Verbrennungsmotors gedämpft über ein Verbindungsbauteil angebracht ist, ist es eine Aufgabe der Erfindung, das Verbindungsbauteil so zu erweitern, dass es zusätzliche Funktionen erfüllt.

Diese Aufgabe wird durch ein Kraftfahrzeug mit den Merkmalen des unabhängigen Anspruchs gelöst. Vorteilhafte Ausführungsformen und Anwendungen der Erfindung ergeben sich aus den abhängigen Ansprüchen.

Die Vorrichtung zur Anbringung eines Steuergeräts, vorzugsweise eines elektronischen Motorsteuergeräts, an einer Komponente eines Verbrennungsmotors weist ein erstes oder motorseitiges Verbindungsbauteil und ein zweites oder steuergeräteseitiges Verbindungsbauteil auf. Das erste Verbindungsbauteil ist dazu ausgebildet ist, an der Komponente des Verbrennungsmotors angebracht oder befestigt zu werden. Das erste Verbindungsbauteil weist einen ersten Fluidkanal auf. Das zweite Verbindungsbauteil ist über mindestens ein Dämpfungselement an dem ersten Verbindungsbauteil angebracht. Das zweite Verbindungsbauteil ist beabstandet von dem ersten Fluidkanal angeordnet. Das zweite Verbindungsbauteil ist zur Montage des Steuergeräts ausgebildet.

Das erfindungsgemäße Vorsehen eines ersten Fluidkanals in dem ersten Verbindungsbauteil ermöglicht, dass das erste Verbindungsbauteil mehrere Funktionen erfüllt. Das erste Verbindungsbauteil dient einerseits weiterhin zur Anbringung eines Steuergeräts an einer Komponente des Verbrennungsmotors, zum Beispiel einen Zylinderkopf, eine Zylinderkopfabdeckung oder ein Kurbelgehäuse. Das Steuergerät wird insbesondere über ein zweites Verbindungsbauteil und mindestens ein Dämpfungselement gedämpft an dem ersten Verbindungsbauteil angebracht. Das zweite Verbindungsbauteil ist außen an dem ersten Verbindungsbauteil über das oder die Dämpfungselemente angebracht. Neben der Anbringung des Steuergeräts weist das erste Verbindungsbauteil eine weitere Funktion auf. Das erste Verbindungsbauteil ist dazu verwendbar, ein für den Betrieb des Verbrennungsmotors notwendiges Fluid in dem ersten Fluidkanal zu führen. Hierbei kann es sich beispielsweise um Ladeluft, Abgas, Hydraulikflüssigkeit, Kühlmittel, Kraftstoff, Druckluft oder Schmiermittel handeln. Folglich kann das erste Verbindungsbauteil beispielsweise in ein Ladeluftsystem des Verbrennungsmotors integriert werden. Der erste Fluidkanal kann beispielsweise einen Abschnitt einer Einlassluftleitung oder einer Abgasrückführleitung des Ladeluftsystems bilden. Das erste Verbindungsbauteil und/oder das zweite Verbindungsbauteil können insbesondere als Konsolen vorgesehen sein. Das erste Verbindungsbauteil kann fest mit der Komponente des Verbrennungsmotors verbunden sein. Das zweite Verbindungsbauteil kann fest mit dem Steuergerät verbunden sein. Das zweite Verbindungsbauteil ist über das mindestens eine Dämpfungselement gedämpft mit dem ersten Verbindungsbauteil verbunden, sodass das Steuergerät gedämpft mit der Komponente des Verbrennungsmotors verbunden ist. Das Steuergerät und das zweite Verbindungsbauteil können außerhalb des ersten Fluidkanals angeordnet sein. Das Dämpfungselement oder Entkopplungselement kann ein elastischer Körper sein, zum Beispiel ein Gummielement, das beispielsweise ein Durchgangsloch zur Befestigung des Gummielements mittels einer Schraube, eines Bolzens usw. aufweist. Das Dämpfungselement dämpft die Schwingungen zwischen dem ersten Verbindungsbauteil und dem zweiten Verbindungsbauteil, sodass die Schwingungen von dem Verbrennungsmotor gedämpft auf das Steuergerät übertragen werden. Es können eine Mehrzahl von zueinander beabstandeten Dämpfungselementen verwendet werden, die beispielsweise an Positionen mit Schwingungsmaxima des ersten Verbindungsbauteils befestigt sind.

Gemäß einer Ausführungsform weist das erste Verbindungsbauteil einen zweiten Fluidkanal auf. Der zweite Fluidkanal kann insbesondere getrennt vom ersten Fluidkanal vorgesehen sein und/oder im Wesentlichen parallel zu dem ersten Fluidkanal verlaufen. Somit kann das erste Verbindungsbauteil ein zweites Medium in dem zweiten Fluidkanal führen.

Vorteilhafterweise ist mindestens ein Befestigungsbereich zwischen einem ersten Fluidkanal (dem ersten Rohrstück mit dem ersten Fluidkanal) und einem zweiten Fluidkanal (dem zweiten Rohrstückmit dem zweiten Fluidkanal) angeordnet. Der mindestens eine Befestigungsbereich ist zur Befestigung von einen des mindestens einen Dämpfungselements ausgebildet. Alternativ oder zusätzlich ist der mindestens eine Befestigungsbereich zur Montage des ersten Verbindungsbauteils an der Komponente des Verbrennungsmotors ausgebildet. Folglich kann die Positionierung der Befestigungsbereiche mit Blick auf einen einfachen Zugang zur Montage verbessert werden. Eine Positionierung zwischen den Fluidkanälen kann ferner die Dämpfung dadurch verbessern, dass Dämpfungselemente gegebenenfalls dichter an Positionen mit Schwingungsmaxima positioniert werden können. Zudem wird ermöglicht, dass die Kanalverläufe der Fluidkanäle nicht negativ beeinflusst werden.

In einem Ausführungsbeispiel sind ein erstes Rohrstück mit dem ersten Fluidkanal und ein zweites Rohrstück mit dem zweiten Fluidkanal durch mindestens eine Versteifungsrippe miteinander verbunden. Dies ermöglicht eine Erhöhung der Steifigkeit des ersten Verbindungsbauteils.

Ein besonders bevorzugtes Ausführungsbeispiel sieht hierbei vor, dass das erste Verbindungsbauteil mindestens einen Befestigungsbereich zur Befestigung des mindestens einen Dämpfungselements, ein erstes Rohrstück mit dem ersten Fluidkanal und/oder ein zweites Rohrstück mit dem zweiten Fluidkanalaufweist. Das erste Rohrstück, das zweite Rohrstück und/oder der mindestens eine Befestigungsbereich sind integral miteinander ausgebildet (aus einem Stück gefertigt oder hergestellt). Somit kann die Teilezahl gegenüber einer herkömmlichen Konstruktion, bei der ein Verbindungsbauteil und ein oder zwei Rohrstücke mit Fluidkanal separat voneinander vorgesehen sind, verringert werden. Dies ermöglicht eine montage- und gewichtsgünstige Konstruktion.

Alternativ oder zusätzlich kann das erste Verbindungsbauteil ein Gussteil sein. Die zusätzlichen Funktionen (z. B. Medienführung in Fluidkanälen und Aufnahme von Sensoren) des ersten Verbindungsbauteils lassen sich somit mit geringem konstruktiven Mehraufwand an dem ersten Verbindungsbauteil verwirklichen. Das im Gießverfahren hergestellte erste Verbindungsbauteil kann beispielsweise mittels eines spanabhebenden Verfahrens zum Aufweisen der zusätzlichen Funktion(en) nachbearbeitet werden.

Gemäß einer weiteren Ausführungsvariante weist das erste Verbindungsbauteil ferner mindestens eine Sensoraufnahme zur Aufnahme eines Sensors auf. Dies ermöglicht, dass das erste Verbindungsbauteil eine weitere zusätzliche Funktion übernimmt. Das erste Verbindungsbauteil dient zusätzlich als eine Halterung für einen Sensor. Die mindestens eine Sensoraufnahme kann insbesondere in den ersten Fluidkanal und/oder den zweiten Fluidkanal münden. Folglich können Messungen die ein durch den ersten oder zweiten Fluidkanal strömendes Fluid betreffen, von einem in der Sensoraufnahme positionieren Sensor durchgeführt werden.

Vorteilhafterweise weist der erste Fluidkanal und/oder der zweite Fluidkanal einen Venturirohrabschnitt (Venturidüsenabschnitt) auf und die mindestens eine Sensoraufnahme mündet insbesondere in den Venturirohrabschnitt. Ein Venturirohr ist durch eine Verengung eines Strömungsquerschnitts eines Kanals gekennzeichnet. Somit kann die Innengeometrie des ersten Fluidkanals und/oder des zweiten Fluidkanals an das Messprinzip eines Sensors in der Sensoraufnahme angepasst sein. Mit anderen Worten gesagt, kann die einen Venturirohrabschnitt aufweisende Innengeometrie des ersten Fluidkanals die Messung gemäß dem Messprinzip des verwendeten Sensors erst ermöglichen.

In einigen Ausführungsformen kann die Vorrichtung ferner mindestens einen Sensor aufweisen, der in der mindestens einen Sensoraufnahme aufgenommen ist. Der Sensor kann beispielsweise ein Drucksensor, ein Temperatursensor oder ein Durchflussmengensensor sein. Der Sensor kann so in der Sensoraufnahme vorgesehen sein, dass er funktional mit dem ersten Fluidkanal und/oder dem zweiten Fluidkanal verbunden ist. Zum Beispiel kann der Sensor in den Fluidkanal zur Messung eines Fluiddrucks, einer Fluiddurchflussmenge, und/oder einer Fluidtemperatur zumindest teilweise hineinragen.

Vorzugsweise ist an die Vorrichtung ferner eine Durchflussmengenänderungseinrichtung angebaut. Die Durchflussmengenänderungseinrichtung kann beispielsweise eine Drosselklappe oder ein Ventil sein. Die Durchflussmengenänderungseinrichtung kann an einem Einlass des ersten Fluidkanals, an einem Einlass des zweiten Fluidkanals, in dem ersten Fluidkanal, in dem zweiten Fluidkanal, an einem Auslass des ersten Fluidkanals und/oder an einem Auslass des zweiten Fluidkanals vorgesehen sein. Somit wird eine weitere Funktion, nämlich die Möglichkeit, eine Durchflussmenge durch den ersten Fluidkanal und/oder den zweiten Fluidkanal zu verändern, in das erste Verbindungsbauteil integriert.

Weitere Bauteile können an den Einlass, in den ersten Fluidkanal und/oder an den Auslass des ersten Fluidkanals und/oder des zweiten Fluidkanals eingebaut oder angebaut werden. Diese Bauteile umfassen beispielsweise Filter, Umlenkbleche, Rohrleitungen usw.

In einem weiteren Ausführungsbeispiel weist der erste Fluidkanal und/oder der zweite Fluidkanal einen Einlass oder mehrere Einlässe zum Vereinigen von mehreren Teilströmungen und einen Auslass oder mehrere Auslässe zum Verzweigen in mehrere Teilströmungen auf. Dies ermöglicht eine flexible Anpassung an das Leitungssystem, in das der erste Fluidkanal und/oder der zweite Fluidkanal des ersten Verbindungsbauteils, zu integrieren ist.

Alternativ oder zusätzlich kann der erste Fluidkanal und/oder der zweite Fluidkanal mehrgängig ausgeführt sein, d. h. mehrere (Teil-) Strömungsgänge aufweisen.

Vorzugsweise weist das mindestens eine Dämpfungselement eine Mehrzahl von Dämpfungselementen auf, die an zueinander beabstandeten Positionen des ersten Verbindungsbauteils angeordnet sind. Die Mehrzahl von Dämpfungselementen sind im Einbauzustand des ersten Verbindungsbauteils, d. h. im an der Komponente des Verbrennungsmotors montierten Zustand, insbesondere in einer Vertikalrichtung und/oder in einer Horizontalrichtung voneinander beabstandet.

Die Erfindung betrifft ein Kraftfahrzeug, insbesondere ein Nutzfahrzeug, mit einem Der Verbrennungsmotor weist die Vorrichtung zur Anbringung eines Steuergeräts wie hierin offenbart auf. Der erste Fluidkanal und/oder der zweite Fluidkanal des ersten Verbindungsbauteils bildet einen Abschnitt einer Einlassluftleitung des Verbrennungsmotors, einen Abschnitt einer Abgasleitung des Verbrennungsmotors, einen Abschnitt einer Abgasrückführleitung des Verbrennungsmotors, einen Abschnitt einer Druckluftleitung des Verbrennungsmotors, einen Abschnitt einer Hydraulikleitung des Verbrennungsmotors, einen Abschnitt einer Ölleitung des Verbrennungsmotors, einen Abschnitt einer Kraftstoffleitung des Verbrennungsmotors oder einen Abschnitt einer Kühlmittelleitung des Verbrennungsmotors.

Die Komponente, an der das erste Verbindungsbauteil montiert wird, ist erfindungsgemäß ein Kurbelgehäuse, ein Zylinderkopf und/oder eine Zylinderkopfabdeckung.

Die Erfindung betrifft weiterhin ein Kraftfahrzeug, insbesondere ein Nutzfahrzug, mit einer Vorrichtung zur Anbringung eines Steuergeräts an einer Komponente eines Verbrennungsmotors wie hierin offenbart oder einem Verbrennungsmotor wie hierin offenbart.

Gemäß einem weiteren Gesichtspunkt der Erfindung kann ein (erstes oder motorseitiges) Verbindungsbauteil einer Vorrichtung zur Anbringung eines Steuergeräts an einer Komponente eines Verbrennungsmotors vorgesehen sein. Das Verbindungsbauteil ist dazu ausgebildet, an der Komponenten des Verbrennungsmotors angebracht zu werden. Das Verbindungsbauteil weist mindestens einen Fluidkanal, insbesondere einen ersten Fluidkanal und einen zweiten Fluidkanal, auf. Der erste Fluidkanal kann sich durch ein erstes Rohrstück und der zweite Fluidkanal kann sich durch ein zweites Rohrstück erstrecken. Das Verbindungsbauteil weist ferner einen Befestigungsbereich auf, der zur Befestigung von mindestens einem Dämpfungselement zur Anbringung eines weiteren Verbindungsbauteils zur Montage des Steuergeräts an dem Verbindungsbauteil ausgebildet ist. Das weitere Verbindungsbauteil, das mindestens eine Dämpfungselement und/oder der Befestigungsbereich sind beabstandet von dem ersten Fluidkanal und/oder dem zweiten Fluidkanal angeordnet. Das erste Rohrstück, das zweite Rohrstück und/oder der Befestigungsbereich können insbesondere integral miteinander, zum Beispiel als ein Gussteil, ausgebildet sein. Das Verbindungsbauteil kann wie das hierin offenbarte erste Verbindungsbauteil ausgebildet sein.

Die zuvor beschriebenen bevorzugten Ausführungsformen und Merkmale der Erfindung sind beliebig miteinander kombinierbar. Weitere Einzelheiten und Vorteile der Erfindung werden im Folgenden unter Bezug auf die beigefügten Zeichnungen beschrieben. Es zeigen:
- Figur 1: eine perspektivische Ansicht eines Verbrennungsmotors mit einer Vorrichtung zur Anbringung eines Steuergeräts;
- Figur 2: eine Schnittansicht durch einen Bereich des Verbrennungsmotors und der Vorrichtung zur Anbringung des Steuergeräts;
- Figur 3A: eine perspektivische Vorderansicht eines ersten Verbindungsbauteils der Vorrichtung zur Anbringung des Steuergeräts;
- Figur 3B: eine perspektivische Rückansicht des ersten Verbindungsbauteils; und
- Figur 4: eine Längsschnittansicht durch ein erstes Rohrstück des ersten Verbindungsbauteils.

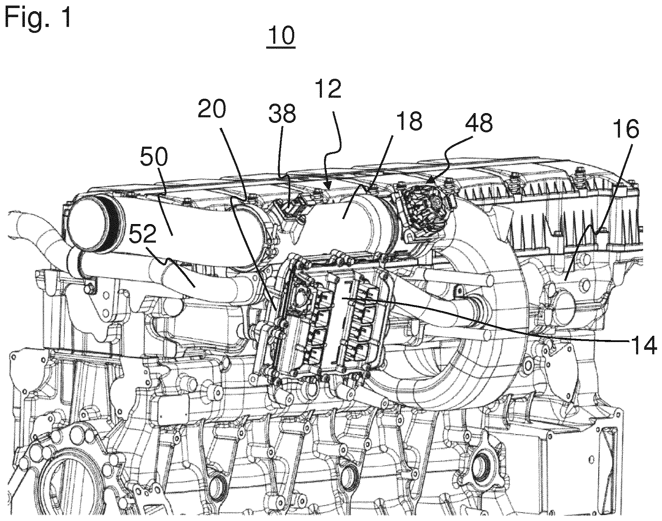

Die Figur 1 zeigt einen Bereich eines Verbrennungsmotors 10. Der Verbrennungsmotor 10 weist eine Vorrichtung 12 zur Anbringung eines Steuergeräts (elektronischen Motorsteuergeräts) 14 an einer Komponente 16 des Verbrennungsmotors 10 auf. In dem gezeigten Ausführungsbeispiel ist die Komponente 16 ein Zylinderkopf. In anderen Ausführungsformen kann die Komponente 16 beispielsweise ein Kurbelgehäuse oder eine Zylinderkopfabdeckung sein.

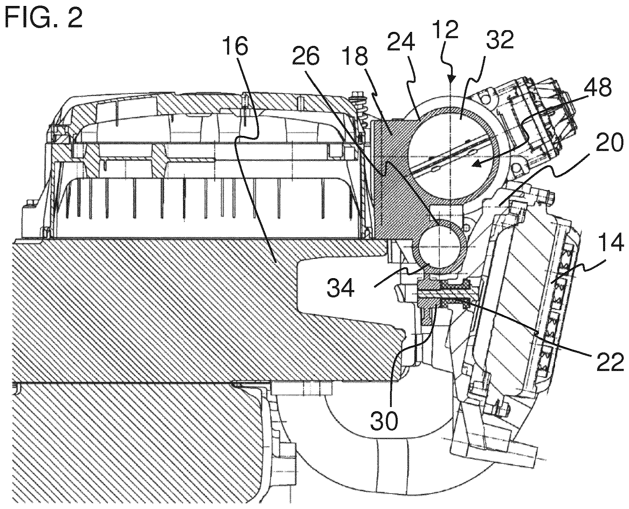

Die Vorrichtung 12 zur Anbringung des Steuergeräts 14 weist ein erstes Verbindungsbauteil 18, ein zweites Verbindungsbauteil 20 und eine Mehrzahl von Dämpfungselementen oder Entkopplungselementen 22 (vgl. Figur 2; verdeckt in Figur 1) auf.

Wie der Figur 2 entnommen werden kann, sind die Dämpfungselemente 22 zwischen dem ersten Verbindungsbauteil 18 und dem zweiten Verbindungsbauteil 20 angeordnet. Die Dämpfungselemente 22 dämpfen Schwingungen zwischen den Verbindungsbauteilen 18, 20. Die Dämpfungselemente 22 dienen zum (zumindest teilweisen) Entkoppeln des Steuergeräts 14 von dem im Betrieb vibrierenden Verbrennungsmotor 10.

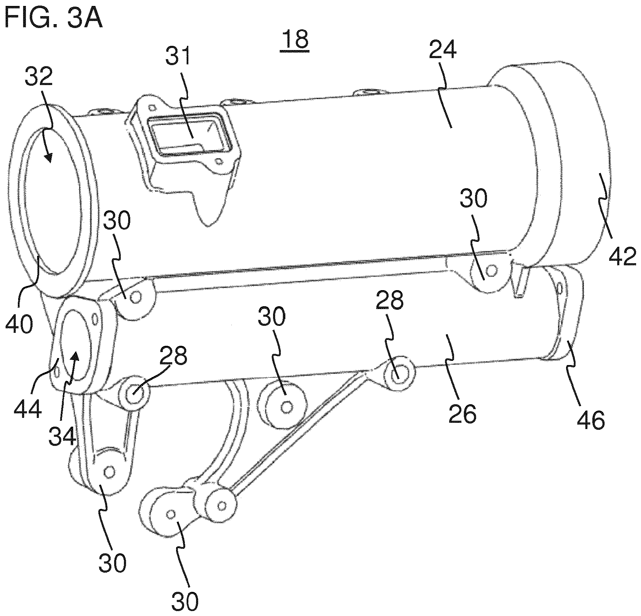

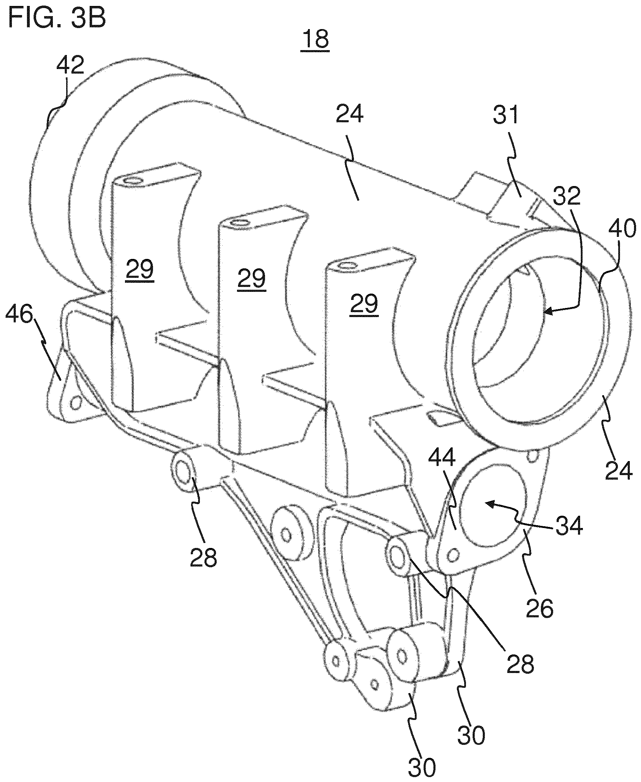

Nachfolgend ist das erste Verbindungsbauteil 18 unter Bezugnahme auf die Figuren 2 bis 4 beschrieben. Das erste Verbindungsbauteil 18 weist ein erstes Rohrstück 24, ein zweites Rohrstück 26, eine Mehrzahl von ersten und zweiten Befestigungsbereichen 28 und 30 (siehe Figuren 3A und 3B) und eine Sensoraufnahme 31 auf. Das erste Rohrstück 24, das zweite Rohrstück 26 und die Befestigungsbereiche 28, 30 sind einstückig miteinander als ein Gussteil vorgesehen. Das erste Rohrstück 24 und das zweite Rohrstück 26 sind über eine Mehrzahl von Versteifungsrippen 29 miteinander verbunden.

Ein erster Fluidkanal 32 erstreckt sich durch das erste Rohrstück 24 zwischen einem ersten Einlass 40 und einem ersten Auslass 42. Ein zweiter Fluidkanal 34 erstreckt sich durch das zweite Rohrstück 26 zwischen einem zweiten Einlass 44 und einem zweiten Auslass 46. Der erste Fluidkanal 32 und/oder der zweite Fluidkanal 34 können mehrere Einlässe und/oder Auslässe aufweisen und auch mehrgängig ausgestaltet sein. Die Einlässe 40, 44 und die Auslässe 42, 46 können als Flansche zum Anschluss an Leitungen des Verbrennungsmotors 10 (zum Beispiel eine Einlassluftleitung 50, eine Abgasrückführleitung 52, vgl. Figur 1) ausgebildet sein. Der erste Auslass 42 des ersten Rohrstücks 24 ist so ausgebildet, dass eine Drosselklappenvorrichtung 48 an dem ersten Auslass 42 angebracht werden kann (vgl. Figur 1). Die Flansche können allgemein so ausgeführt werden, dass weitere Bauteile, die für die Funktion des Verbrennungsmotors 10 benötigt werden, direkt angebaut werden können. So ergeben sich erhebliche Freiheiten bei der Montage und Demontage von Bauteilen im Servicefall.

Der erste Fluidkanal 32 und der zweite Fluidkanal 34 erstrecken sich im Wesentlichen geradlinig und parallel zueinander. Der erste Fluidkanal 32 und das erste Rohrstück 24 bilden einen Abschnitt der Ladeluftleitung 50 (siehe Figur 1) eines Einlassluftsystems des Verbrennungsmotors 10. Der zweite Fluidkanal 34 und das zweite Rohrstück 26 bilden einen Abschnitt der Abgasrückführleitung 52 (siehe Figur 1) des Verbrennungsmotors 10. Die Rohrstücke 24, 26 sind beispielsweise über geeignete Schellen und Flansche in die Leitungen 50, 52 integriert, d. h. als Leitungsabschnitte mit anderen Leitungsabschnitten der Leitungen 50, 52 verbunden. Der erste Fluidkanal 32 und der zweite Fluidkanal 34 können unterschiedliche Strömungsquerschnitte aufweisen, die an die jeweilige Funktion angepasst sind. Der Strömungsquerschnitt des als Einlassluftkanal verwendeten ersten Fluidkanals 32 ist größer als der Strömungsquerschnitt des als Abgasrückführungskanals verwendeten zweiten Fluidkanals 34.

Die ersten Befestigungsbereiche 28 sind dazu ausgebildet, das erste Verbindungsbauteil 18 an dem Zylinderkopf 16 (siehe Figur 1) zu befestigen. Die ersten Befestigungsbereiche 28 können beispielsweise als Durchgangslöcher vorgesehen sein, in die Schrauben oder dergleichen einführbar sind. Die Schrauben befestigen das erste Verbindungsbauteil 18 an dem Zylinderkopf 16. In der dargestellten Ausführungsform sind zwei erste Befestigungsbereiche 28 vorgesehen. In anderen Ausführungsformen können mehr oder weniger erste Befestigungsbereiche 28 vorgesehen sein.

Die zweiten Befestigungsbereiche 30 sind dazu ausgebildet, die Dämpfungselemente 22 an dem ersten Verbindungsbauteil 18 zu befestigen, sodass das zweite Verbindungsbauteil 20 über die Dämpfungselemente 22 (siehe Figur 2) an dem ersten Verbindungsbauteil 18 anbringbar ist. Dazu kann beispielsweise eine Schraube oder dergleichen von dem zweiten Verbindungsbauteil 20 durch ein Durchgangsloch in dem Dämpfungselement 22 in eine Öffnung im zweiten Befestigungsbereich 30 eingeschraubt werden. Wie insbesondere der Figur 3A zu entnehmen ist, weist die gezeigte Ausführungsform fünf zueinander beabstandete zweite Befestigungsbereiche 30 auf. Die zweiten Befestigungsbereiche 30 sind so positioniert, dass die Schwingung von dem ersten Verbindungsbauteil 18 zu dem zweiten Verbindungsbauteil 20 durch Vorsehen der Dämpfungselemente 22 an den zweiten Befestigungsbereichen 30 möglichst gut gedämpft werden. Mit anderen Worten gesagt, sind die zweiten Befestigungsbereiche 30 und die Dämpfungselemente 22 insbesondere an Positionen mit Schwingungsmaxima im Betrieb des Verbrennungsmotors 10 angeordnet. Zum Beispiel sind zwei zweite Befestigungsbereiche 30 zwischen dem ersten Rohrstück 24 und dem zweiten Rohrstück 26 positioniert (siehe Figur 3A). Weitere drei Befestigungsbereiche 30 sind im Einbauzustand unterhalb des zweiten Rohrstücks 26 positioniert. Damit sind die Befestigungsschrauben für Schraubwerkzeuge gut zugänglich angeordnet.

Die ersten und zweiten Befestigungsbereiche 28 und 30 sind so angeordnet und ausgebildet, dass die Kanalführungen des ersten Fluidkanal 32 und des zweiten Fluidkanals 34 nicht oder in möglichst geringen Umfang beeinträchtigt werden (besonders trifft dies für den Strömungskanal 32 zu). Somit kann eine strömungsgünstige, glattwandige (ebenwandige) Leitungsführung insbesondere des ersten Fluidkanals 32 ohne einengende Schraubbutzen oder dergleichen ermöglicht werden. D.h., der erste Fluidkanal 32 erfährt keine Veränderung des Strömungsquerschnitts durch Vorsehen der ersten und zweiten Befestigungsbereiche 28 und 30.

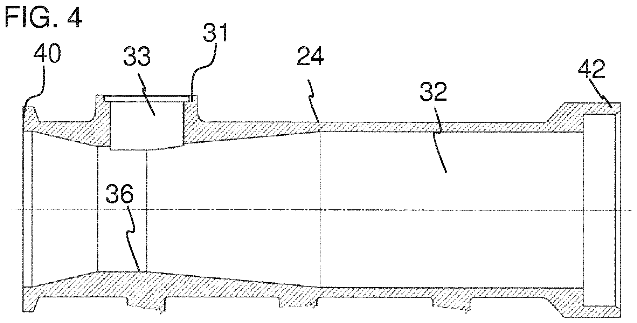

Die Sensoraufnahme 31 ist an dem ersten Rohrstück 24 angeordnet. Die Sensoraufnahme 31 weist einen Sensorkanal 33 auf, der in den ersten Fluidkanal 32 mündet (vgl. Figur 4). An der Sensoraufnahme 31 kann ein Sensor 38 (vgl. Figur 1) befestigt werden. Der Sensor 38 kann durch den Sensorkanal 33 eingeführt werden, sodass er zumindest teilweise in den ersten Fluidkanal 32 hineinragt. Der Sensor 38 kann beispielsweise ein Drucksensor, ein Temperatursensor oder ein Durchflussmengensensor sein. Eine Innenumfangsfläche des ersten Fluidkanals 32 kann einen Venturirohrabschnitt 36 (definierte Verengung des Strömungsquerschnitts des ersten Fluidkanals 32) aufweisen. In der gezeigten Ausführungsform ermöglicht der Venturirohrabschnitt 36, dass für ein durch den ersten Fluidkanal 32 strömendes flüssiges oder gasförmiges Medium der dynamische Druck (Staudruck) an der engsten Stelle des ersten Fluidkanals 32 maximal und der statische Druck minimal wird. So kann beispielsweise unter Berücksichtigung einer gemessenen Medientemperatur und der bekannten Querschnittsfläche im engsten Querschnitt des Venturirohrabschnitts 36 die durchströmende Medienmenge berechnet werden. Die engste Querschnittsfläche kann insbesondere durch mechanische Bearbeitung hergestellt werden, sodass deren Istgröße möglichst genau der für die Berechnung herangezogenen Sollgröße entspricht. Die engste Querschnittsfläche kann aber auch durch einen Gießprozess mit hinreichender Genauigkeit dargestellt werden. Allgemein kann der erste Fluidkanal 32 somit an ein Messprinzip oder eine Messanforderung des Sensors 38 angepasst sein. In anderen Ausführungsformen können mehr oder weniger Sensoren mit entsprechenden Sensoraufnahmen und gegebenenfalls angepassten Geometrien des ersten oder zweiten Fluidkanals 32, 34 an dem ersten und/oder dem zweiten Rohrstück 24, 26 vorgesehen sein.

Nachfolgend ist das zweite Verbindungsbauteil 20 unter Bezugnahme auf die Figuren 1 und 2 beschrieben. Das zweite Verbindungsbauteil 20 ist (einzig) über die Dämpfungselemente 22 mit dem ersten Verbindungsbauteil 18 (gedämpft) verbunden. Das Steuergerät 14 ist an das zweite Verbindungsbauteil 20 montiert, zum Beispiel angeschraubt. Das zweite Verbindungsbauteil 20 ist außen an dem ersten Verbindungsbauteil 18 angebracht. Das Steuergerät 14 und das zweite Verbindungsbauteil 20 sind außerhalb des ersten Fluidkanals 32 und des zweiten Fluidkanals 34 angeordnet. Das zweite Verbindungsbauteil 20 trägt das Steuergerät 14.

Die Erfindung ist nicht auf die vorstehend beschriebenen bevorzugten Ausführungsbeispiele beschränkt. Vielmehr ist eine Vielzahl von Varianten und Abwandlungen möglich, die unter den Wortlaut der Ansprüche fallen.

### Bezugszeichenliste

- 10: Verbrennungsmotor
- 12: Verbindungsvorrichtung
- 14: Steuergerät
- 16: Kurbelgehäuse
- 18: erstes Verbindungsbauteil
- 20: zweites Verbindungsbauteil
- 22: Dämpfungselement
- 24: erstes Rohrstück
- 26: zweites Rohrstück
- 28: erster Befestigungsbereich
- 29: Versteifungsrippe
- 30: zweiter Befestigungsbereich
- 31: Sensoraufnahme
- 32: erster Fluidkanal
- 33: Sensorkanal
- 34: zweiter Fluidkanal
- 36: Venturirohrabschnitt
- 38: Sensor
- 40: erster Einlass
- 42: erster Auslass
- 44: zweiter Einlass
- 46: zweiter Auslass
- 48: Drosselklappenvorrichtung
- 50: Einlassluftleitung
- 52: Abgasrückführleitung

## Patentansprüche

1. Kraftfahrzeug, insbesondere Nutzfahrzeug, aufweisend:
einen Verbrennungsmotor (10) mit einer Komponente (16), die als ein Kurbelgehäuse, ein Zylinderkopf oder eine Zylinderkopfabdeckung ausgebildet ist;
ein Steuergerät (14), vorzugsweise ein elektronisches Motorsteuergerät; und
eine Vorrichtung (12), die das Steuergerät (14) an der Komponente (16) des Verbrennungsmotors (10) anbringt, wobei die Vorrichtung (12) aufweist:
- ein erstes Verbindungsbauteil (18), das an der Komponente (16) des Verbrennungsmotors (10) angebracht ist, wobei das erste Verbindungsbauteil (18) einen ersten Fluidkanal (32) aufweist, und
- ein zweites Verbindungsbauteil (20), das über mindestens ein Dämpfungselement (22) an dem ersten Verbindungsbauteil (18) beabstandet zu dem ersten Fluidkanal (32) angebracht und zur Montage des Steuergeräts (14) ausgebildet ist.

2. Kraftfahrzeug nach Anspruch 1, wobei das erste Verbindungsbauteil (18) einen zweiten Fluidkanal (34) aufweist, der insbesondere getrennt vom ersten Fluidkanal (32) vorgesehen ist und/oder im Wesentlichen parallel zu dem ersten Fluidkanal (32) verläuft.

3. Kraftfahrzeug nach Anspruch 2, wobei mindestens ein Befestigungsbereich (28, 30) zwischen dem ersten Fluidkanal (32) und dem zweiten Fluidkanal (34) angeordnet und zur Befestigung von einem des mindestens einen Dämpfungselements (22) und/oder des ersten Verbindungsbauteils (18) an der Komponente (16) des Verbrennungsmotors (10) ausgebildet ist.

4. Kraftfahrzeug nach Anspruch 2 oder Anspruch 3, wobei ein erstes Rohrstück (24) mit dem ersten Fluidkanal (32) und ein zweites Rohrstück (26) mit dem zweiten Fluidkanal (34) durch mindestens eine Versteifungsrippe (29) miteinander verbunden sind.

5. Kraftfahrzeug nach einem der Ansprüche 1 oder 2, wobei:
das erste Verbindungsbauteil (18) mindestens einen Befestigungsbereich (30) zur Befestigung des mindestens einen Dämpfungselements (22), ein erstes Rohrstück (24) mit dem ersten Fluidkanal (32) und/oder ein zweites Rohrstück (26) mit dem zweiten Fluidkanal (34) aufweist, wobei das erste Rohrstück (24), das zweite Rohrstück (26) und/oder der mindestens eine Befestigungsbereich (30) integral miteinander ausgebildet sind, und/oder
das erste Verbindungsbauteil (18) ein Gussteil ist.

6. Kraftfahrzeug nach einem der vorherigen Ansprüche, wobei das erste Verbindungsbauteil (18) ferner mindestens eine Sensoraufnahme (31) zur Aufnahme eines Sensors (38) aufweist, die insbesondere in den ersten Fluidkanal (32) und/oder in den zweiten Fluidkanal (34) mündet.

7. Kraftfahrzeug nach Anspruch 6, wobei:
der erste Fluidkanal (32) und/oder der zweite Fluidkanal (34) einen Venturirohrabschnitt (36) aufweist und die mindestens eine Sensoraufnahme (31) insbesondere in den Venturirohrabschnitt (36) mündet, und/oder
die Vorrichtung (12) ferner mindestens einen Sensor (38), insbesondere einen Drucksensor, einen Temperatursensor und/oder einen Durchflussmengensensor, aufweist, wobei der mindestens eine Sensor (38) vorzugsweise in der mindestens einen Sensoraufnahme (31) angeordnet ist.

8. Kraftfahrzeug nach einem der vorherigen Ansprüche, ferner aufweisend mindestens eine Durchflussmengenänderungseinrichtung (48), insbesondere eine Drosselklappe oder ein Ventil, die an einem Einlass (40) des ersten Fluidkanals (32), an einem Einlass (44) des zweiten Fluidkanals (34), in dem ersten Fluidkanal (32), in dem zweiten Fluidkanal (34), an einem Auslass (42) des ersten Fluidkanals (32) und/oder an einem Auslass (46) des zweiten Fluidkanals (34) vorgesehen ist.

9. Kraftfahrzeug nach einem der vorherigen Ansprüche, wobei:
der erste Fluidkanal (32) und/oder der zweite Fluidkanal (34) einen oder mehrere Einlässe (40, 44) zum Vereinigen von mehreren Teilströmungen und einen oder mehrere Auslässe (42, 56) zum Verzweigen in mehrere Teilströmungen aufweist, und/oder
der erste Fluidkanal (32) und/oder der zweite Fluidkanal (34) mehrgängig ausgeführt ist.

10. Kraftfahrzeug nach einem der vorherigen Ansprüche, wobei das mindestens eine Dämpfungselement (22) eine Mehrzahl von Dämpfungselementen (22) aufweist, die an zueinander beabstandeten Positionen des ersten Verbindungsbauteils (18) angeordnet sind, wobei die Mehrzahl von Dämpfungselementen (22) im Einbauzustand des ersten Verbindungsbauteils (18) insbesondere in einer Vertikalrichtung und/oder in einer Horizontalrichtung voneinander beabstandet sind.

11. Kraftfahrzeug nach einem der vorherigen Ansprüche, wobei der erste Fluidkanal (32) und/oder der zweite Fluidkanal (34) einen Abschnitt einer Einlassluftleitung (50) des Verbrennungsmotors (10), einen Abschnitt einer Abgasleitung des Verbrennungsmotors (10), einen Abschnitt einer Abgasrückführleitung (52) des Verbrennungsmotors (10), einen Abschnitt einer Druckluftleitung des Verbrennungsmotors (10), einen Abschnitt einer Hydraulikleitung des Verbrennungsmotors (10), einen Abschnitt einer Ölleitung des Verbrennungsmotors (10), einen Abschnitt einer Kraftstoffleitung des Verbrennungsmotors (10) oder einen Abschnitt einer Kühlmittelleitung des Verbrennungsmotors (10) bildet.

## Claims

1. A motor vehicle, in particular utility vehicle, having:
an internal combustion engine (10) with a component (16) which is formed as a crankcase, a cylinder head or a cylinder head cover;
a control unit (14), preferably an electronic engine control unit; and
a device (12) which attaches the control unit (14) to the component (16) of the internal combustion engine (10), the device (12) comprising:
- a first connecting component (18) which is attached to the component (16) of the internal combustion engine (10), the first connecting component (18) comprising a first fluid duct (32), and
- a second connecting component (20), which, via at least one damping element (22), is attached, spaced from the first fluid duct (32), to the first connecting component (18) and which is designed for the mounting of the control unit (14).

2. The motor vehicle according to Claim 1, wherein the first connecting component (18) comprises a second fluid duct (34) which is provided in particular separately from the first fluid duct (32) and/or runs substantially parallel to the first fluid duct (32).

3. The motor vehicle according to Claim 2, wherein at least one fastening region (28, 30) is arranged between the first fluid duct (32) and the second fluid duct (34) and is designed for fastening one of the at least one damping element (22) and/or of the first connecting component (18) to the component (16) of the internal combustion engine (10).

4. The motor vehicle according to Claim 2 or Claim 3, wherein a first pipe section (24) with the first fluid duct (32) and a second pipe section (26) with the second fluid duct (34) are connected to one another by at least one stiffening rib (29).

5. The motor vehicle according to either of Claims 1 and 2, wherein:
the first connecting component (18) comprises at least one fastening region (30) for fastening the at least one damping element (22), a first pipe section (24) with the first fluid duct (32) and/or a second pipe section (26) with the second fluid duct (34), the first pipe section (24), the second pipe section (26) and/or the at least one fastening region (30) being formed integrally with one another, and/or
the first connecting component (18) being a casting.

6. The motor vehicle according to any one of the preceding claims, wherein the first connecting component (18) furthermore comprises at least one sensor mounting (31) for receiving a sensor (38), which leads in particular into the first fluid duct (32) and/or into the second fluid duct (34).

7. The motor vehicle according to Claim 6, wherein:
the first fluid duct (32) and/or the second fluid duct (34) comprise(s) a venturi pipe section (36) and the at least one sensor mounting (31) leads in particular into the venturi pipe section (36), and/or
the device (12) furthermore comprises at least one sensor (38), in particular a pressure sensor, a temperature sensor and/or a flow rate sensor, the at least one sensor (38) being preferentially arranged in the at least one sensor mounting (31)

8. The motor vehicle according to any one of the preceding claims, furthermore comprising at least one flow rate changing device (48), in particular a throttle valve or a valve, which is provided at an inlet (40) of the first fluid duct (32), at an inlet (44) of the second fluid duct (34), in the first fluid duct (32), in the second fluid duct (34), at an outlet (42) of the first fluid duct (32) and/or at an outlet (46) of the second fluid duct (34).

9. The motor vehicle according to any one of the preceding claims, wherein:
the first fluid duct (32) and/or the second fluid duct (34) comprise(s) one or a plurality of inlets (40, 44) for uniting a plurality of part flows and one or a plurality of outlets (42, 56) for branching into a plurality of part flows, and/or
the first fluid duct (32) and/or the second fluid duct (34) is embodied in multiple passages.

10. The motor vehicle according to any one of the preceding claims, wherein the at least one damping element (22) comprises a plurality of damping elements (22) which are arranged in positions of the first connecting component (18) spaced from one another, wherein in the installed state of the first connecting component (18), the plurality of damping elements (22) are spaced from one another in particular in a vertical direction and/or in a horizontal direction.

11. The motor vehicle according to any of the preceding claims, wherein the first fluid duct (32) and/or the second fluid duct (34) form(s) a section of an intake air line (50) of the internal combustion engine (10), a section of an exhaust line of the internal combustion engine (10), a section of an exhaust gas recirculation line (52) of the internal combustion engine (10), a section of a compressed-air line of the internal combustion engine (10), a section of a hydraulic line of the internal combustion engine (10), a section of an oil line of the internal combustion engine (10), a section of a fuel line of the internal combustion engine (10) or a section of a coolant line of the internal combustion engine (10).

## Revendications

1. Véhicule à moteur, en particulier véhicule utilitaire, comprenant :
un moteur à combustion interne (10) doté d'un composant (16) qui est réalisé en tant que carter de vilebrequin, culasse ou couvre-culasse ;
une unité de commande (14), de préférence une unité de commande de moteur électronique ; et
un dispositif (12) qui fixe l'unité de commande (14) au composant (16) du moteur à combustion interne (10), dans lequel le dispositif (12) comprend :
- une première partie structurale de liaison (18) qui est fixée au composant (16) du moteur à combustion interne (10), dans lequel la première partie structurale de liaison (18) comprend un premier canal de fluide (32), et
- une deuxième partie structurale de liaison (20) qui est fixée à la première partie structurale de liaison (18) par le biais d'au moins un élément d'amortissement (22) de manière espacée du premier canal de fluide (32) et est conçue pour le montage de l'unité de commande (14) .

2. Véhicule à moteur selon la revendication 1, dans lequel la première partie structurale de liaison (18) comprend un deuxième canal de fluide (34) qui est prévu en particulier de manière séparée du premier canal de fluide (32) et/ou s'étend sensiblement parallèlement au premier canal de fluide (32).

3. Véhicule à moteur selon la revendication 2, dans lequel au moins une région de fixation (28, 30) est disposée entre le premier canal de fluide (32) et le deuxième canal de fluide (34) et est conçue pour la fixation, au composant (16) du moteur à combustion interne (10), de l'un parmi l'au moins un élément d'amortissement (22) et/ou la première partie structurale de liaison (18).

4. Véhicule à moteur selon la revendication 2 ou la revendication 3, dans lequel une première pièce tubulaire (24) dotée du premier canal de fluide (32) et une deuxième pièce tubulaire (26) dotée du deuxième canal de fluide (34) sont reliées l'une à l'autre par au moins une nervure de raidissement (29).

5. Véhicule à moteur selon l'une des revendications 1 ou 2, dans lequel :
la première partie structurale de liaison (18) comprend au moins une région de fixation (30) pour la fixation de l'au moins un élément d'amortissement (22), une première pièce tubulaire (24) dotée du premier canal de fluide (32) et/ou une deuxième pièce tubulaire (26) dotée du deuxième canal de fluide (34), dans lequel la première pièce tubulaire (24), la deuxième pièce tubulaire (26) et/ou l'au moins une région de fixation (30) sont réalisées d'un seul tenant les unes avec les autres, et/ou
la première partie structurale de liaison (18) est une pièce coulée.

6. Véhicule à moteur selon l'une des revendications précédentes, dans lequel la première partie structurale de liaison (18) comprend en outre au moins un logement de capteur (31) pour le logement d'un capteur (38), lequel logement débouche en particulier dans le premier canal de fluide (32) et/ou dans le deuxième canal de fluide (34).

7. Véhicule à moteur selon la revendication 6, dans lequel :
le premier canal de fluide (32) et/ou le deuxième canal de fluide (34) comprennent une partie de tube de Venturi (36) et l'au moins un logement de capteur (31) débouche en particulier dans la partie de tube de Venturi (36), et/ou
le dispositif (12) comprend en outre au moins un capteur (38), en particulier un capteur de pression, un capteur de température et/ou un capteur de débit, dans lequel l'au moins un capteur (38) est disposé de préférence dans l'au moins un logement de capteur (31).

8. Véhicule à moteur selon l'une des revendications précédentes, comprenant en outre au moins un dispositif de variation de débit (48), en particulier un clapet d'étranglement ou une soupape, qui est disposé (e) au niveau d'une entrée (40) du premier canal de fluide (32), au niveau d'une entrée (44) du deuxième canal de fluide (34), dans le premier canal de fluide (32), dans le deuxième canal de fluide (34), au niveau d'une sortie (42) du premier canal de fluide (32) et/ou au niveau d'une sortie (46) du deuxième canal de fluide (34).

9. Véhicule à moteur selon l'une des revendications précédentes, dans lequel :
le premier canal de fluide (32) et/ou le deuxième canal de fluide (34) comprennent une ou plusieurs entrées (40, 44) pour combiner plusieurs écoulements partiels et une ou plusieurs sorties (42, 56) pour la bifurcation en plusieurs écoulements partiels, et/ou
le premier canal de fluide (32) et/ou le deuxième canal de fluide (34) présentent plusieurs voies.

10. Véhicule à moteur selon l'une des revendications précédentes, dans lequel l'au moins un élément d'amortissement (22) comprend une pluralité d'éléments d'amortissement (22) qui sont disposés à des positions, espacées les unes des autres, de la première partie structurale de liaison (18), dans lequel la pluralité d'éléments d'amortissement (22), à l'état installé de la première partie structurale de liaison (18), sont espacés les uns des autres en particulier dans une direction verticale et/ou dans une direction horizontale.

11. Véhicule à moteur selon l'une des revendications précédentes, dans lequel le premier canal de fluide (32) et/ou le deuxième canal de fluide (34) forment une partie d'une conduite d'air d'admission (50) du moteur à combustion interne (10), une partie d'une conduite de gaz d'échappement du moteur à combustion interne (10), une partie d'une conduite de recirculation des gaz d'échappement (52) du moteur à combustion interne (10), une partie d'une conduite d'air comprimé du moteur à combustion interne (10), une partie d'une conduite hydraulique du moteur à combustion interne (10), une partie d'une conduite d'huile du moteur à combustion interne (10), une partie d'une conduite de carburant du moteur à combustion interne (10) ou une partie d'une conduite de liquide de refroidissement du moteur à combustion interne (10).
